# EUROPEAN PATENT SPECIFICATION

(11) **EP 2 730 622 B1**
(45) Date of publication and mention of the grant of the patent: **03.02.2016**
(21) Application number: 12191703.3
(22) Date of filing: 07.11.2012
(51) Int. Cl.: C09B 47/00, C09B 67/22, H01G 9/20, H01L 51/00

(54) **Dye-sensitized solar cells and methods of making same**
Farbstoffsensibilisierte Solarzellen und Verfahren zu deren Herstellung
Cellules solaires à colorant et leurs procédés de fabrication

(43) Date of publication of application: 14.05.2014
(73) Proprietor: Honeywell Romania S.R.L., 014459 Bucharest (RO)
(72) Inventor: Serban, Bogdan, Catalin, 60000 Bucharest, sector 2 (RO); Mihaila, Mihai, N., 023555 Bucharest, sector 1 (RO); Diaconu, Christian, Morristown NJ 07962-2245 (US); Buiu, Octavian, Morristown NJ 07962-2245 (US)
(74) Representative: Houghton, Mark Phillip

(56) References cited:
- WANG ET AL: "A dye-sensitized solar cell using pheophytin-carotenoid adduct: Enhancement of photocurrent by electron and singlet-energy transfer and by suppression of singlet-triplet annihilation due to the presence of the carotenoid moiety", CHEMICAL PHYSICS LETTERS, ELSEVIER BV, NL, vol. 439, no. 1-3, 24 April 2007 (2007-04-24), pages 115-120, XP022046845, ISSN: 0009-2614, DOI: 10.1016/J.CPLETT.2007.03.064
- WANG X F ET AL: "Dye-sensitized solar cells using a chlorophyll a derivative as the sensitizer and carotenoids having different conjugation lengths as redox spacers", CHEMICAL PHYSICS LETTERS, ELSEVIER BV, NL, vol. 408, no. 4-6, 17 June 2005 (2005-06-17), pages 409-414, XP027647063, ISSN: 0009-2614, DOI: 10.1016/J.CPLETT.2005.04.067 [retrieved on 2005-06-17]
- XIAO-FENG WANG ET AL: "Chlorophyll- a Derivatives with Various Hydrocarbon Ester Groups for Efficient Dye-Sensitized Solar Cells: Static and Ultrafast Evaluations on Electron Injection and Charge Collection Processes", LANGMUIR, vol. 26, no. 9, 4 May 2010 (2010-05-04), pages 6320-6327, XP055056583, ISSN: 0743-7463, DOI: 10.1021/la1005715
- D. V. BELYKH ET AL: "Transformations of the extra ring in pheophorbide a methyl ester in the reaction with N,N,N',N'-tetramethylmethanediamine", RUSSIAN JOURNAL OF ORGANIC CHEMISTRY, vol. 45, no. 3, 1 March 2009 (2009-03-01), pages 452-459, XP055056588, ISSN: 1070-4280, DOI: 10.1134/S1070428009030191

## Description

### FIELD OF INVENTION

The present disclosure relates to dye-sensitized solar cells and a method for making same. More particularly, the disclosure relates to a dye-sensitized solar cell that utilizes a tetrapyrrole macrocycle as the dye-sensitizer.

### BACKGROUND OF THE INVENTION

Dye-sensitized solar cells (DSSC) provide a technically and economically credible alternative concept to present day p-n junction photovoltaic devices (M. Grätzel, Journal of Photochemistry and Photobiology C: Photochemistry Reviews 4: 145-153 (2003). *See also,* Wei-Hao Lai et al., Journal of Photochemistry and Photobiology A: Chemistry 195: 307-313 (2008); and Xiao-Feng Wang et al., Langmuir 26: 6320-6327 (2010)). In contrast to the conventional systems where the semiconductor assumes both the task of light absorption and charge carrier transport, the two functions are separated in the case of DSSCs. Light is absorbed by a sensitizer, which is anchored to the surface of a semiconductor. Charge separation takes place at the interface via photo-induced electron injection from the dye into the conduction band of the solid. Carriers are transported in the conduction band of the semiconductor to the charge collector. The use of sensitizers having a broad absorption band in conjunction with oxide films of nanocrystalline morphology permits the harvesting of a large fraction of sunlight, with nearly quantitative conversion of incident photon into electric current over a large spectral range extending from the UV to the near IR region. [0002a] X. F. WANG et al, discloses "A dye-sensitized solar cell using pheophytin-carotenoid adduct: Enhancement of photocurrent by electron and singlet-energy transfer and by suppression of singlet-triplet annihilation due to the presence of the carotenoid moiety" as set out in Chemical Physiscs Letters, Elsevier BV, NL, vol. 439, no. 1 -3, 24 April 2007, pages 115-120, XP022046845 and also discloses "Dye-sensitized solar cells using a chlorophyll a derivative as the sensitizer and carotenoids having different conjugation lengths as redox spacers" in Chemical Physiscs Letters, Elsevier BV, NL, vol. 408, no. 4-6,17 June 2005, pages 409-41 4, XP027 647063.

June 2005, pages 409-41 4, XP027 647063;Tetrapyrrole macrocycles, including chlorophylls, have attracted attention in the past in DSSC applications as sensitizers primarily because they are known chromrophores that play an important role in natural photosynthetic processes. It is known, however, that tetrapyrrole macrocycles suffer some drawbacks due in part to their lack of red light and near IR absorption. There is therefore a need in the art for tetrapyrrole macrocycle sensitizers that do not suffer from some of these drawbacks. The embodiments of the present address this need.

### SUMMARY OF THE INVENTION

The present invention in its various aspects is as set out in the appended claims. The embodiments of the present disclosure focus on tetrapyrrole macrocycle dye-sensitizers in DSSC applications due to their low toxicity; ease of production in large scale; and the possibility of modifying the organic and inorganic portions of the tetrapyrrole macrocycle, thereby modifying the absorption wavelength of the dye-sensitizer. The tetrapyrrole macrocycle can be modified in such a way as to make it "tunable." For example, the inorganic portion of the tetrapyrrole macrocycle can be modified by changing the metal *(e.g.,* Mg, Zn, and Cu), thereby adjusting the energy difference between the highest occupied molecular orbital (HOMO) and the lowest unoccupied molecular orbital (LUMO). The ultimate result of "tuning" the HOMO-LUMO energy separation is that the absorption wavelength of the sensitizer can be tuned. Tunability of the HOMO-LUMO energy separation is important because it affects the oxidation potential of the sensitizer and, in turn, the electronic coupling of the sensitizer.

In one embodiment the invention relates to a dye-sensitized solar cell comprising a dye compound of the formula (I): 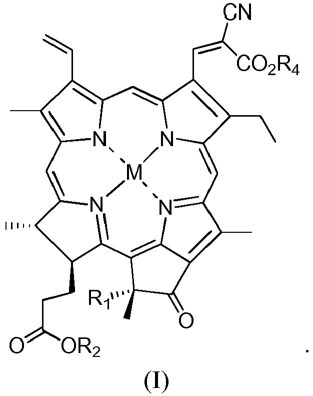 or mixtures thereof;
wherein M is 2H or a divalent cation;
R₁ is CO₂R₃, wherein R₃ is alkyl;
R₂ is hydrogen, C₁₂-C₂₀ alkyl group or a C₁₂-C₂₀ alkenyl group; and
R₄ is hydrogen or alkyl.

In another embodiment, the invention relates to a method of preparing a dye sensitized solar cell comprising:
forming a first conductive layer on a first substrate;
forming a barrier layer on the first conductive layer;
forming a TiO₂ nanoparticulate layer;
forming a TiO₂ microparticulate layer on the TiO₂ nanoparticulate layer;
disposing a dye on the TiO₂ nanoparticulate layer and/or the TiO₂ microparticulate layer, wherein the dye comprises a compound of the formula (I): 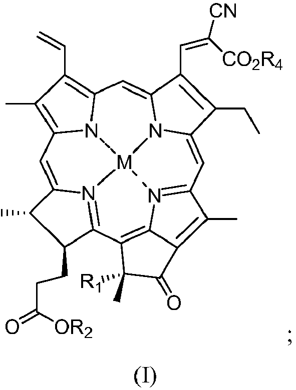 or mixtures thereof;
wherein M is 2H or a divalent cation;
R₁ is CO₂R₃, wherein R₃ is alkyl;
R₂ is hydrogen, C₁₂-C₂₀ alkyl group or a C₁₂-C₂₀ alkenyl group; and
R₄ is hydrogen or alkyl;
forming a second conductive layer on a second substrate; and
providing a regenerating composition between the second conductive layer and the barrier layer.

In still another embodiment, the invention relates to a method of preparing a dye sensitized solar cell comprising:
providing a first substrate comprising a first conductive layer and a TiO₂ nanoparticulate layer;
disposing a dye on the TiO₂ nanoparticulate layer, wherein the dye comprises a compound of the formula (I): 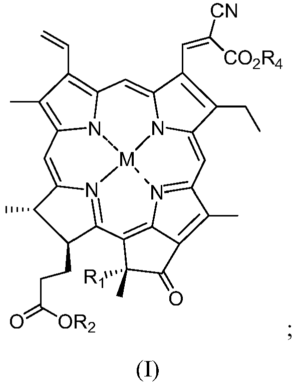 or mixtures thereof;
wherein M is 2H or a divalent cation;
R₁ is CO₂R₃, wherein R₃ is alkyl;
R₂ is hydrogen, C₁₂-C₂₀ alkyl group or a C₁₂-C₂₀ alkenyl group; and
R₄ is hydrogen or alkyl; and
providing a second substrate comprising a second conductive layer.

### DETAILED DESCRIPTION OF THE DRAWINGS

FIG. 1 is a cross-section of a DSSC prepared by the methods disclosed herein.
FIGS. 2A to 2F are cross-sections of a DSSC according to an embodiment of the invention, as it is prepared by the methods disclosed herein.
FIG. 3 is a cross-section of a DSSC according to an embodiment of the invention.
FIG. 4 is a flow chart of the method of preparing a DSSC according to an embodiment of the invention.

### DETAILED DESCRIPTION OF THE INVENTION

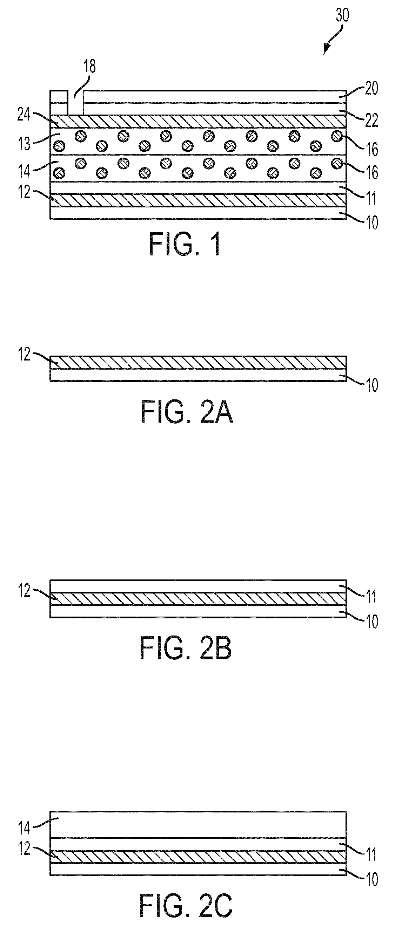

Embodiments of the present invention relate to a method of preparing a dye-sensitized solar cell. Making reference to FIG. 1, the method comprises forming a first conductive layer 12 on a first substrate 10. A barrier layer 11 is then formed on the conductive layer 12. A nanoparticulate layer 14 is subsequently formed on the metal oxide layer 11. A microparticulate layer 13 is subsequently formed on the nanoparticulate layer 14. The nanoparticulate layer 14 and the microparticulate layer 13 are subsequently functionalized with a dye 16. A second substrate 20 comprising a second conductive layer 22 is provided and a regenerating composition 24 *(e.g.,* an electrolyte composition for regenerating the dye 16) is applied between the first substrate 10 and the second substrate 20, thereby completing the dye-sensitized solar cell 30. Those of skill in the art will appreciate that the regenerating composition 24, though shown as a layer in FIG. 1, will permeate the space between the barrier layer 11 and the second conductive layer 22. In some embodiments, the second substrate 20 comprises at least one orifice 18 that goes through the second substrate 20 and the second conductive layer 22 and allows for the application of the regenerating composition 24.

Although the layers shown in FIG. 1 (and others) are shown as being in direct contact with one another, it should be understood that, in some embodiments, there could be one or more layers in between the layers depicted in FIG. 1.

More specifically, referring to FIG. 2A, a first substrate 10 is provided. The first substrate 10 may comprises any suitable material and may be rigid, flexible, transparent, semitransparent, metallic or semiconducting. In some embodiments, the first substrate 10 may be glass or polymeric in nature, *e.g.*, flexible polymers including, but not limited to, poly(ethylene terephthalate, poly(ethylene naphthalate) or mixtures thereof.

In FIG. 2A, a first conductive layer 12 is formed on the first substrate 10 to provide a path for electron flow. In some embodiments, the first conductive layer 12 may be substantially smooth. In other embodiments, the first conductive layer 12 may comprise protrusions that may be characterized as nanowires or nanorods. *See, e.g.,* Published U.S. Patent Appl. No. 2008/0041446. In some embodiments, the first conductive layer 12 is formed by an *in situ* process including, but not limited to, thermal evaporation, sputtering or other applicable processes well-known in the art. For example, the first conductive layer 12, comprising, *e.g.,* indium tin oxide, may be formed on the first substrate 10, and then stacked and saturated in a vapor of indium tin oxide by thermal evaporation. The first conductive layer 12 is formed at a temperature, *e.g.,* between 400°C and 950°C for 5 minutes to 60 minutes.

In some embodiments, the first conductive layer 12 comprises indium tin oxide (ITO), aluminum doped zinc oxide (AZO), antimony doped tin dioxide (ATO), fluorine doped tin oxide (FTO), tin-doped indium oxide or other semiconductor oxides.

In some embodiments, the first substrate 10 is flexible. In some embodiments, the flexible substrate comprises poly(ethylene terephthalate) coated with a first conductive layer 12 comprising tin-doped indium oxide. In other embodiments, the flexible substrate comprises poly(ethylene naphthalate) coated with tin-doped indium oxide.

As shown in FIG. 2B, in some embodiments a barrier layer 11 is formed on the first conductive layer 12. The barrier layer 11 may be formed by, *e.g.,* immersing the first substrate 10, comprising the conductive layer 12, in a TiCl₄ solution at 70°C. Following the immersion in the TiCl₄ solution, the first substrate 10 is heated at about 450°C for about 40 minutes. The resulting barrier layer 11 is, in some embodiments, a TiO₂ nanoparticulate layer having a 100-150 nm thicknes and having nanoparticles having an average diameter of about 3 nm. The barrier layer 11 is formed to, among other things, avoid contact between the conductive layer 12 and the regenerating composition 24.

As shown in FIG. 2C, a nanoparticulate layer 14 is then formed on the barrier layer 11 by, *e.g.,* the doctor blade method or any other method known in the art. The nanoparticulate layer 14 is formed to, among other things, increase surface contact with the subsequently applied dye-sensitizer. The nanoparticulate layer 14 may take the form of nanoparticles, nanorods (*e.g.*, nanowires) or quantum dots.

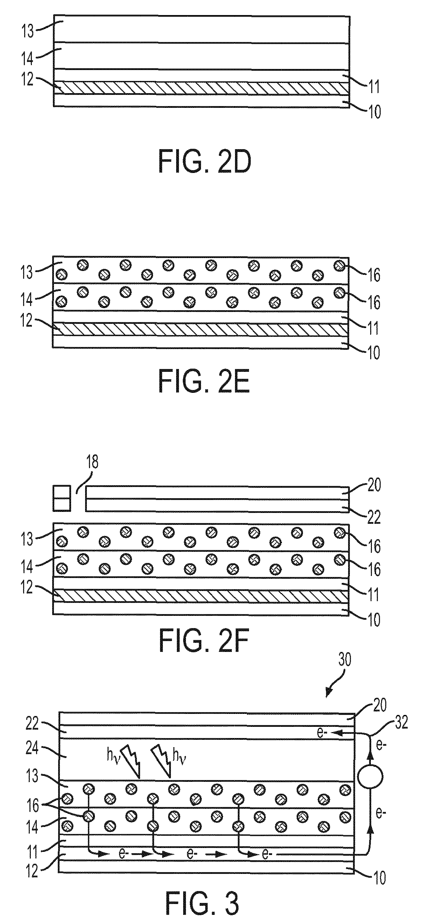

In FIG. 2D, a microparticulate layer 13 is formed on the nanoparticulate layer 14. The microparticulate layer 13 may be formed by, *e.g.,* the doctor blade method or any other method known in the art. The newly-formed microparticulate layer 13 is heated at 450°C, for about 30 minutes and then allowed to cool slowly to a temperature of about 80°C. It is at about this temperature that the dye 16 is provided.

In FIG. 2E, a dye 16 is provided in the nanoparticulate layer 14 and in the microparticulate layer 13. In some embodiments, the dye 16 is adsorbed on the nanoparticulate layer 14 and the microparticulate layer 13, *e.g*., by dipping the substrate comprising the nanoparticulate layer 14 and the microparticulate layer 13 into a dye solution comprising the dye 16 at a concentration of about 0.3 mM to about 0.8 mM at room temperature for about 30 minutes to about 24 hours (*e.g.,* from about 10 hours to about 24 hours). In some embodiments, the dye 16 comprises one or more dyes comprising a tetrapyrrole macrocycle compound of the formula (I): 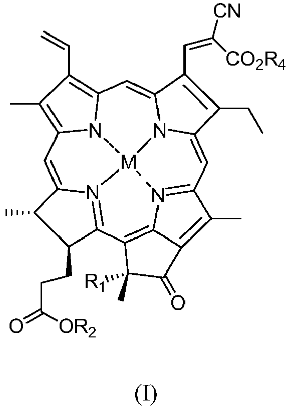 or mixtures thereof, wherein M is 2H or a divalent cation; R₁ is CO₂R₃, wherein R₃ is alkyl; R₂ is hydrogen, a C₁₂-C₂₀ alkyl group or a C₁₂-C₂₀ alkenyl group; and R₄ is hydrogen or alkyl.

As used herein, the term "divalent cation" refers to a cation that is in the +2 oxidation state. Exemplary divalent cations include, but are not limited to, Mn⁺², Co⁺², Sn⁺², Ni⁺², Cu⁺², Zn⁺², and Mg⁺².

As used herein, the term "alkyl" refers broadly to a straight or branched chain saturated hydrocarbon radical. "Alkyl" also refers broadly to cyclic (*i.e.,* cycloalkyl) alkyl groups. Examples of alkyl groups include, but are not limited to, straight chained alkyl groups including methyl, ethyl, n-propyl, n-butyl, n-pentyl, n-hexyl, n-heptyl, n-octyl, and branched alkyl groups including isopropyl, tert-butyl, iso-amyl, neopentyl, iso-amyl, and the like. "Cycloalkyl" or "cyclic alkyl" as used herein refers to carbocycles containing no heteroatoms, and includes mono-, bi- and tricyclic saturated carbocycles, as well as fused ring systems. Examples of cycloalkyl include cyclopropyl, cyclobutyl, cyclopentyl, cyclohexyl, cycloheptyl, and the like. The cycloalkyl can be substituted or unsubstituted. Such alkyl groups may be optionally substituted as described herein.

As used herein, the term "C₁₂-C₂₀ alkenyl" refers broadly to a straight or branched chain hydrocarbon radical having one or more double bonds and containing from 12 to 20 carbon atoms. Also contemplated are C₁₂-C₁₆ alkenyl, C₁₆-C₂₀ alkenyl, C₁₂-C₁₈ alkenyl, and C₁₈-C₂₀ alkenyl. Examples of C₁₂-C₂₀ alkenyl groups include phytyl, palmitoleyl, oleyl, elaidyl, linoleyl, elaidolinoleyl, erucyl and the like. The C₁₂-C₂₀ alkenyl, C₁₂-C₁₆ alkenyl, C₁₆-C₂₀ alkenyl, C₁₂-C₁₈ alkenyl or C₁₈-C₂₀ alkenyl groups may be optionally substituted as described herein. Table I, below, gives the structural representation of the phytyl, palmitoleyl, oleyl, elaidyl, linoleyl, linoelaidyl, and erucyl alkenyl groups, where the wavy line indicates the point of attachment to the oxygen of OR₂.

**Table I**

| | |
|---|---|
| Phytyl | 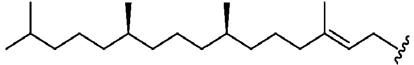 |
| Palmitoleyl | 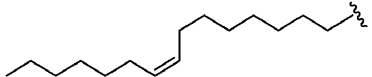 |
| Oleyl | 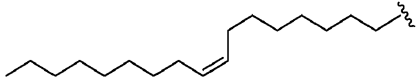 |
| Elaidyl | 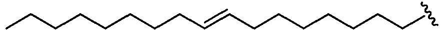 |
| Linoleyl | 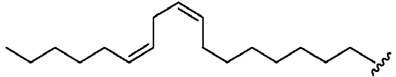 |
| Linoelaidyl | 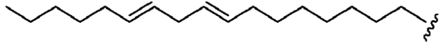 |
| Erucyl | 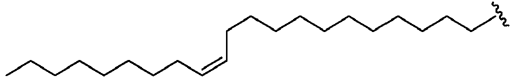 |

As used herein, the term "C₁₂-C₂₀ alkyl" refers broadly to a saturated, straight or branched chain hydrocarbon radical containing from 12 to 20 carbon atoms. Also contemplated are C₁₂-C₁₆ alkyl, C₁₆-C₂₀ alkyl, C₁₂-C₁₈ alkyl, and C₁₈-C₂₀ alkyl. The C₁₂-C₂₀ alkyl, C₁₂-C₁₆ alkyl, C₁₆-C₂₀ alkyl, C₁₂-C₁₈ alkyl or C₁₈-C₂₀ alkyl groups may be optionally substituted as described herein.

"Substituted" as used herein refers broadly to replacement of one or more of the hydrogen atoms of the group replaced by substituents known to those skilled in the art and resulting in a stable compound as described below. Examples of suitable replacement groups include, but are not limited to, alkyl, alkenyl, alkynyl, cycloalkyl, aryl, alkaryl, hydroxy, alkoxy, aryloxy, carboxy (*i.e.,* CO₂H), carboxyalkyl, carboxyaryl, cyano, nitro and the like.

In some embodiments, the dye 16 further comprises a tetraterpene including, but not limited to, lycopene, gamma-carotene, and alpha- or beta-carotenes. In other embodiments, the dye layer 16 further comprises a carotenoid comprising 9-13 double bonds including, but not limited to neurosporene, spheroidene, lycopene, anhydrorhodovibrin, and spirilloxanthin. *See, e.g.,* Xiao-Feng Wang et al., Chem Phys. Lett. 408: 409-414 (2005). In some embodiments, the dye 16 further comprises a mixture of one or more tetraterpenes and one or more carotenoids.

While not being bound by theory, such tetraterpenes and carotenoids are believed to act as conjugated spacers that neutralize the dye radical cation and block reverse electron transfer. The tetraterpenes are present at a concentration of about 0.3 mM to about 0.8 mM. The carotenoids are present at a concentration of about 0.3 mM to about 0.8 mM.

In some embodiments, the compound of the formula (I) is synthesized via a Knöevenagel condensation of a compound of the formula (II): 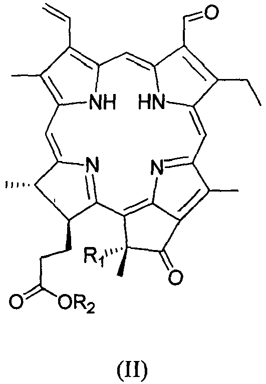 wherein R₁ and R₂ are as defined above;
and a compound of the formula (III) 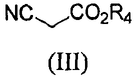 wherein R₄ is as defined above;
in the presence of a base. In some embodiments, the base is an amine base including, but not limited to, pyrrolidine, piperdine, and the like.

In some embodiments, the compound of the formula (II) is pheophorbide b (R₁ = CO₂R₃, wherein R₃ is methyl; and R₂ is hydrogen); or pheophytin b (R₁ = CO₂R₃, wherein R₃ is methyl; and R₂ is phytyl).

Referring to FIG. 2F, a second substrate 20 comprising a second conductive layer 22 is provided. The second conductive layer 22 is formed on the second substrate 20 by evaporation, sputtering, electroplating, deposition, or by any applicable process well-known in the art. The material of the second substrate 20 is the same or different from the material of the first substrate 10, as previously described. The second substrate 20 may comprise any suitable material and may be rigid, flexible, transparent, or semitransparent. In some embodiments, the second substrate 20 may be glass or polymeric (*e.g.*, poly(ethylene terephthalate or poly(ethylene naphthalate) in nature. The second conductive layer 22 may be metal comprising copper, platinum, silver, or any conductive material. In some embodiments, the second substrate 20 comprises at least one orifice 18 that goes through the scond substrate 20 and the second conductive layer 22 and allows for the application of the regenerating composition 24.

In FIG. 1, a regenerating composition 24 is applied *(e.g.,* by filling via orifice 18 that goes through the second substrate 20 and the second conductive layer 22) between the first substrate 10 and the second substrate 20, to regenerate the dye 16. Those of skill in the art will appreciate that the regenerating composition 24, though shown as a layer in FIG. 1, will permeate the space between the barrier layer 11 and the second conductive layer 22.

In some embodiments, the regenerating composition 24 comprises iodide ion and iodine. The regenerating composition 24 may be a solution of iodide ion and iodine. For example, the regenerating composition 24 comprises lithium iodide (LiI) and iodine (I₂) each at a concentration of from about 0.1 M to about 0.2 M in an appropriate solvent such as acetonitrile, tetrahydrofuran, pyridine or a 5:1 mixture of acetonitrile/valeronitrile. In some embodiments, the regenerating composition 24 also comprises an imidazolium salt. Exemplary imidazolium salts include 1,2-dimethyl-3-propylimidazolium iodide and 1-butyl-2-methyl imidazolium iodide. In some embodiments, the regenerating composition 24 also comprises a substituted pyridine. Exemplary substituted pyridines include 4-tert-butyl pyridine. Other electrolytes include the Co(II)/Co(III) based redox couples.

Alternatively, the regenerating composition 24 may be in the form of a gel comprising iodide ion and iodine. *See, e.g.,* Published U.S. Patent Appl. No. 2008/0041446 and U.S. Patent No. 8,034,260. Other regenerating compositions 24 are also known in the art and may be used in the embodiments of the present invention. *See, e.g.,* U.S. patent No. 8,222,515.

In some embodiments, the regenerating composition 24 comprises 2,2'7,7'-tetrakis-(N,N-di-p-methoxyphenyl-amine)-9,9'-spirobifluorene (spiro-MeOTAD) or any other substance that can serve to regenerate the dye comprised in the dye layer 16 by reducing the dye comprised in the dye layer 16.

Following application of the regenerating composition 24 *(e.g.,* by filling via orifice 18 that goes through the second substrate 20 and the second conductive layer) between the first substrate 10 and the second substrate 20, in some embodiments, a sealant (not shown) is applied to seal the DSSC. One of the functions of the sealant is to prevent the regenerating composition 24 from escaping from between the barrier layer 11 and the second conductive layer 22. Exemplary sealants include, but are not limited to Surlyn^{®} ethylene methacrylic acid copolymer resins available from DuPont™.

FIG. 3 shows a dye-sensitized solar cell 30 according to an embodiment of the invention. The dye 16 comprised in the nanoparticulate layer 14 and the microparticulate layer 13 is excited with light and transmits electrons into the nanoparticulate layer 14, when dye 16 absorbs solar energy. At this point, the dye 16 is in an oxidized state. As shown, an electric flow path 32 in FIG. 3, electrons are transmitted to the conductive layer 12 to the second conductive layer 22 to generate a current. Thereafter, electrons from regenerating composition 24 are provided to dye 16 for reduction of oxidized dye 16. The above oxidization and reduction of dye 16 is repeatedly performed to generate current continually.

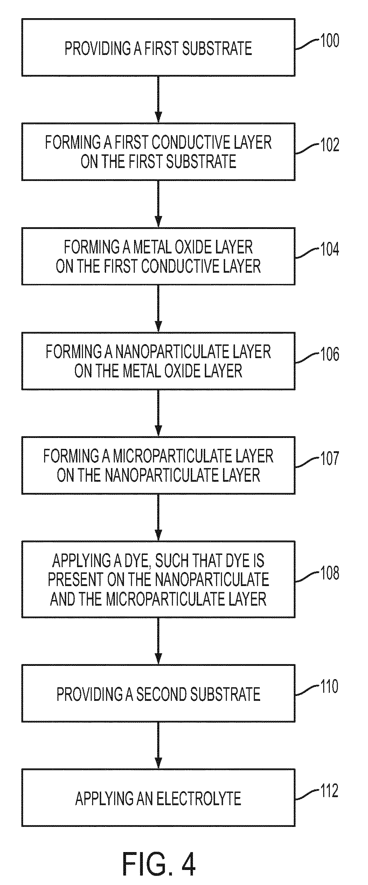

FIG. 4 shows a flow chart for making a dye-sensitized solar cell according to an embodiment of the invention. A first substrate is provided, as step 100. A first conductive layer is formed on the first substrate, as step 102. A barrier layer is formed on the first conductive layer, as step 104. A nanoparticulate layer, comprising a plurality of nanoparticles, is formed on the barrier layer, as step 106. A microparticulate layer is formed on the nanoparticulate layer, as step 107. A dye is then applied on the first substrate by dip coating, as step 108, such that the dye is present in the nanoparticulate layer and/or in the microparticulate layer. Thereafter, a second substrate is provided, as step 110, where the second substrate comprises a second conductive layer. As shown in step 112, a regenerating composition is applied between the substrates to yield a dye-sensitized solar cell, *e.g.,* through an orifice present on the second substrate, that goes through the second conductive layer. In some embodiments, a sealant is provided (step not shown) in a sealing step after the regenerating composition is applied.

### Examples

The following examples are set forth to assist in understanding the embodiments of the invention and should not, of course, be construed as specifically limiting the embodiments of the invention described and claimed herein.

### Example 1

The compound of the formula (I), where R₁ is CO₂R₃, where R₃ is CH₃; R₂ is phytyl; and R₄ is hydrogen is synthesized from pheophytin b and cyanoacetic acid in the presence of piperidine in acetonitrile (MeCN).

Pheophytin b is dissolved in MeCN. To the pheophytin b is added cyanoacetic acid. To this mixture is added piperidine. The reaction mixture is heated. The Zn²⁺ and Cu²⁺ chelates of the resulting product are obtained by heating the resulting product in the presence of Zn²⁺ or Cu²⁺ source in acetic acid.

### Example 2

The compound of the formula (I), where R₁ is CO₂R₃, where R₃ is CH₃; R₂ is hydrogen; and R₄ is hydrogen is synthesized from pheophorbide b and cyanoacetic acid in the presence of piperidine in acetonitrile (MeCN).

Pheophorbide b is dissolved in MeCN. To the pheophytin b is added cyanoacetic acid. To this mixture is added piperidine. The reaction mixture is heated. The Zn²⁺ and Cu²⁺ chelates of the resulting product are obtained by heating the resulting product in the presence of Zn²⁺ or Cu²⁺ source in acetic acid.

### Example 3

A DSSC is prepared by deposition of several layers, including a TiO₂ nanoparticulate layer onto a fluorine-doped tin oxide glass substrate. The substrate comprising the TiO₂ nanoparticulate layer is dipped in a 0.3 mM solution of dye and allowed to soak in the dye solution for 30 minutes. After soaking, the substrate comprising the TiO₂ layer is washed in deionized water, dried, and then washed again in isopropanol.

The DSSC is assembled by placing the substrate comprising the TiO₂ nanoparticulate layer and dye on top of a back conductive surface having an orifice. An electrolyte containing 0.06 M LiI, 0.04 M I₂, 0.5 M 1-butyl-2-methyl imidazolium iodide, 0.5 M 4-tert-butylpyridine in 5:1 acetonitrile/valeronitrile is applied through the orifice, which is subsequently sealed. The completed DSSC is sealed with a low melting point polymer film that served as a gasket.

Embodiments of the invention described and claimed herein are not to be limited in scope by the specific embodiments herein disclosed, since these embodiments are intended as illustration of several aspects of the disclosure.

## Claims

1. A dye-sensitized solar cell comprising a dye compound of the formula (I): 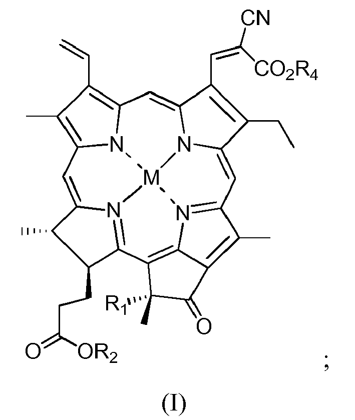 or mixtures thereof;
wherein M is 2H or a divalent cation;
R₁ is CO₂R₃, wherein R₃ is alkyl;
R₂ is hydrogen, C₁₂-C₂₀ alkyl group or a C₁₂-C₂₀ alkenyl group; and
R₄ is hydrogen or alkyl.

2. The dye-sensitized solar cell of claim 1, further comprising:
a first conductive layer disposed on a first substrate;
a barrier layer disposed on the first conductive layer;
a TiO₂ nanoparticulate layer disposed on the barrier layer;
a TiO₂ microparticulate layer disposed on the TiO₂ nanoparticulate layer;
a dye disposed on the TiO₂ nanoparticulate layer and/or the TiO₂ microparticulate layer, wherein the dye comprises a compound of the formula (I): 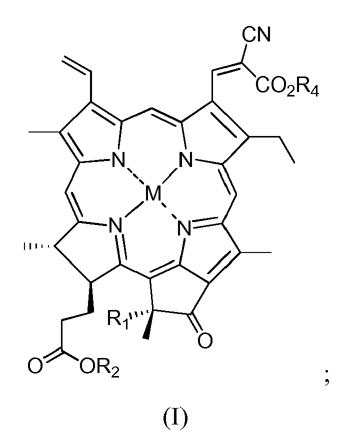 or mixtures thereof;
wherein M is 2H or a divalent cation;
R₁ is CO₂R₃, wherein R₃ is alkyl;
R₂ is hydrogen, C₁₂-C₂₀ alkyl group or a C₁₂-C₂₀ alkenyl group; and
R₄ is hydrogen or alkyl;
a second conductive layer disposed on a second substrate; and
a regenerating composition disposed between the second conductive layer and the TiO₂ microparticulate layer.

3. A method of preparing a dye sensitized solar cell comprising:
forming a first conductive layer on a first substrate;
forming a barrier layer on the first conductive layer;
forming a TiO₂ nanoparticulate layer;
forming a TiO₂ microparticulate layer on the TiO₂ nanoparticulate layer;
disposing a dye on the TiO₂ nanoparticulate layer and/or the TiO₂ microparticulate layer, wherein the dye comprises a compound of the formula (I): 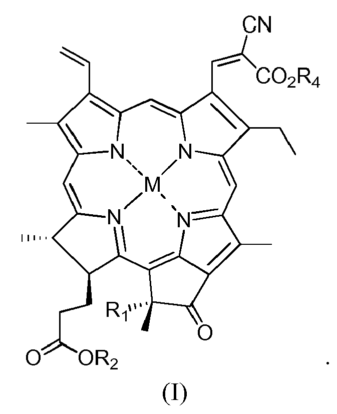 or mixtures thereof;
wherein M is 2H or a divalent cation;
R₁ is CO₂R₃, wherein R₃ is alkyl;
R₂ is hydrogen, C₁₂-C₂₀ alkyl group or a C₁₂-C₂₀ alkenyl group; and
R₄ is hydrogen or alkyl;
forming a second conductive layer on a second substrate; and
providing a regenerating composition between the second conductive layer and the barrier layer.

4. The method of claim 3 or the dye-sensitized solar cell of claim 2 , wherein the divalent cation comprises a divalent cation of Mn, Co, Mg, Zn or Cu.

5. The method of claim 3 or the dye-sensitized solar cell of claim 2 , wherein the dye further comprises a tetraterpene, a carotenoid or a mixture thereof.

6. The method or dye-sensitized solar cell of claim 5 wherein the tetraterpene comprises lycopene, gamma-carotene, alpha-carotene, beta-carotene or mixtures thereof; and the the carotenoid comprises neurosporene, spheroidene, lycopene, anhydrorhodovibrin, spirilloxanthin or mixtures thereof.

7. The method of claim 3 or the dye-sensitized solar cell of claim 2, wherein the first and/or second substrate comprises glass or a flexible polymer.

8. The method or dye-sensitized solar cell of claim 7, wherein the first and/or second substrate comprises a flexible polymer comprising poly(ethylene terephthalate), poly(ethylene naphthalate) or mixtures thereof.

9. The method of claim 3 or the dye-sensitized solar cell of claim 2 wherein the first conductive layer comprises indium tin oxide (ITO), aluminum doped zinc oxide (AZO), antimony doped tin dioxide (ATO), fluorine doped tin dioxide (FTO), tin-doped indium oxide or conductive impurity doped titanium oxide (TiO₂).

10. The method of claim 3 or the dye-sensitized solar cell of claim 2 , wherein the regenerating composition comprises iodide ions and iodine.

11. The method of claim 3 or the dye-sensitized solar cell of claim 2 , wherein the second conductive layer comprises platinum.

12. A method of preparing a dye sensitized solar cell comprising:
providing a first substrate comprising a first conductive layer and a TiO₂ nanoparticulate layer;
disposing a dye on the TiO₂ nanoparticulate layer, wherein the dye comprises a compound of the formula (I): 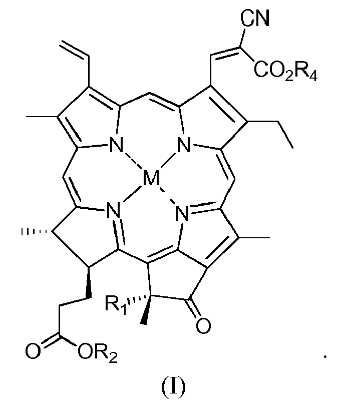 or mixtures thereof;
wherein M is 2H or a divalent cation;
R₁ is CO₂R₃, wherein R₃ is alkyl;
R₂ is hydrogen, C₁₂-C₂₀ alkyl group or a C₁₂-C₂₀ alkenyl group; and
R₄ is hydrogen or alkyl; and
providing a second substrate comprising a second conductive layer.

13. The method of claim 12, wherein the divalent cation comprises a divalent cation of Mn, Co, Mg, Zn or Cu.

14. The method of claim 12, wherein the dye further comprises a tetraterpene, a carotenoid or a mixture thereof.

15. The method of claim 14, wherein the tetraterpene comprises lycopene, gamma-carotene, alpha-carotene, beta-carotene or mixtures thereof; and the the carotenoid comprises neurosporene, spheroidene, lycopene, anhydrorhodovibrin, spirilloxanthin or mixtures thereof.

## Patentansprüche

1. Farbstoffsensibilisierte Solarzelle, umfassend eine Farbstoffverbindung der Formel (I): 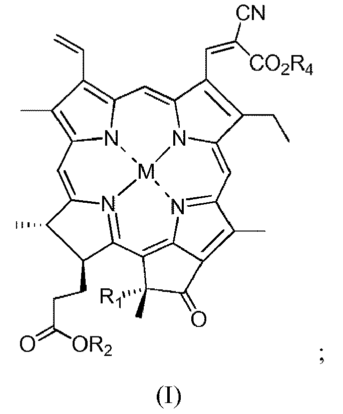 oder Mischungen davon;
wobei M für 2H oder ein zweiwertiges Kation steht;
R₁ für CO₂R₃ steht, wobei R₃ für Alkyl steht;
R₂ für Wasserstoff, eine C₁₂-C₂₀-Alkylgruppe oder eine C₁₂-C₂₀-Alkenylgruppe steht; und
R₄ für Wasserstoff oder Alkyl steht.

2. Farbstoffsensibilisierte Solarzelle nach Anspruch 1, ferner umfassend:
eine auf einem ersten Substrat angeordnete erste leitfähige Schicht;
eine auf der ersten leitfähigen Schicht angeordnete Barriereschicht;
eine auf der Barriereschicht angeordnete TiO₂-Nanopartikelschicht;
eine auf der TiO₂-Nanopartikelschicht angeordnete TiO₂-Mikropartikelschicht;
einen auf der TiO₂-Nanopartikelschicht und/oder der TiO₂-Mikropartikelschicht angeordneten Farbstoff,
wobei der Farbstoff eine Verbindung der Formel (I) : 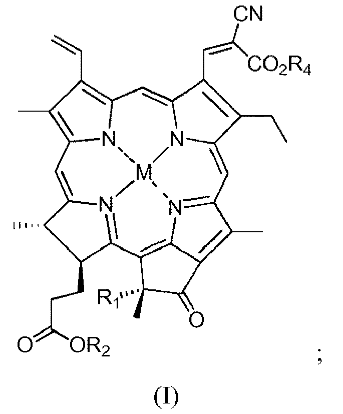 oder Mischungen davon umfasst;
wobei M für 2H oder ein zweiwertiges Kation steht;
R₁ für CO₂R₃ steht, wobei R₃ für Alkyl steht;
R₂ für Wasserstoff, eine C₁₂-C₂₀-Alkylgruppe oder eine C₁₂-C₂₀-Alkenylgruppe steht; und
R₄ für Wasserstoff oder Alkyl steht;
eine auf einem zweiten Substrat angeordnete zweite leitfähige Schicht; und
eine zwischen der zweiten leitfähigen Schicht und der TiO₂-Mikropartikelschicht angeordnete Regenerationszusammensetzung.

3. Verfahren zur Herstellung einer farbstoffsensibilisierten Solarzelle, bei dem man:
auf einem ersten Substrat eine erste leitfähige Schicht bildet;
auf der ersten leitfähigen Schicht eine Barriereschicht bildet;
eine TiO₂-Nanopartikelschicht bildet;
auf der TiO₂-Nanopartikelschicht eine TiO₂-Mikropartikelschicht bildet;
auf der TiO₂-Nanopartikelschicht und/oder der TiO₂-Mikropartikelschicht einen Farbstoff anordnet, wobei der Farbstoff eine Verbindung der Formel (I) : 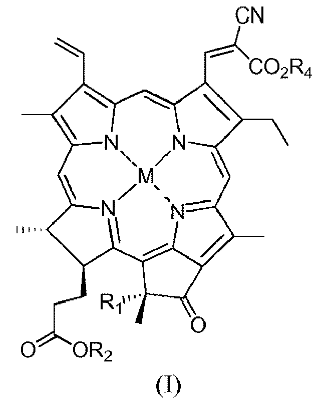 oder Mischungen davon umfasst;
wobei M für 2H oder ein zweiwertiges Kation steht;
R₁ für CO₂R₃ steht, wobei R₃ für Alkyl steht;
R₂ für Wasserstoff, eine C₁₂-C₂₀-Alkylgruppe oder eine C₁₂-C₂₀-Alkenylgruppe steht; und
R₄ für Wasserstoff oder Alkyl steht;
auf einem zweiten Substrat eine zweite leitfähige Schicht bildet; und
zwischen der zweiten leitfähigen Schicht und der Barriereschicht eine Regenerationszusammensetzung bereitstellt.

4. Verfahren nach Anspruch 3 bzw. farbstoffsensibilisierte Solarzelle nach Anspruch 2, wobei das zweiwertige Kation ein zweiwertiges Kation von Mn, Co, Mg, Zn oder Cu umfasst.

5. Verfahren nach Anspruch 3 bzw. farbstoffsensibilisierte Solarzelle nach Anspruch 2, wobei der Farbstoff ferner ein Tetraterpen, ein Carotinoid oder eine Mischung davon umfasst.

6. Verfahren bzw. farbstoffsensibilisierte Solarzelle nach Anspruch 5, wobei das Tetraterpen Lycopin, gamma-Carotin, alpha-Carotin, beta-Carotin oder Mischungen davon umfasst und das Carotinoid Neurosporen, Spheroidin, Lycopin, Anhydrorhodovibrin, Spirilloxanthin oder Mischungen davon umfasst.

7. Verfahren nach Anspruch 3 bzw. farbstoffsensibilisierte Solarzelle nach Anspruch 2, wobei das erste und/oder das zweite Substrat Glas oder ein flexibles Polymer umfassen bzw. umfasst.

8. Verfahren bzw. farbstoffsensibilisierte Solarzelle nach Anspruch 7, wobei das erste und/oder das zweite Substrat ein flexibles Polymer, das Poly-(ethylenterephthalat), Poly(ethylennaphthalat) oder Mischungen davon umfasst, umfassen bzw. umfasst.

9. Verfahren nach Anspruch 3 bzw. farbstoffsensibilisierte Solarzelle nach Anspruch 2, wobei die erste leitfähige Schicht Indiumzinnoxid (ITO), aluminiumdotiertes Zinkoxid (AZO), antimondotiertes Zinndioxid (ATO), fluordotiertes Zinndioxid (FTO), zinndotiertes Indiumoxid oder mit leitfähigen Verunreinigungen dotiertes Titanoxid (TiO₂) umfasst.

10. Verfahren nach Anspruch 3 bzw. farbstoffsensibilisierte Solarzelle nach Anspruch 2, wobei die Regenerationszusammensetzung Iodidionen und Iod umfasst.

11. Verfahren nach Anspruch 3 bzw. farbstoffsensibilisierte Solarzelle nach Anspruch 2, wobei die zweite leitfähige Schicht Platin umfasst.

12. Verfahren zur Herstellung einer farbstoffsensibilisierten Solarzelle, bei dem man:
ein erstes Substrat, das eine erste leitfähige Schicht und eine TiO₂-Nanopartikelschicht umfasst, bereitstellt;
auf der TiO₂-Nanopartikelschicht einen Farbstoff anordnet, wobei der Farbstoff eine Verbindung der Formel (I): 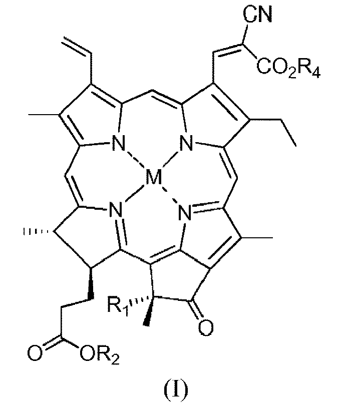 oder Mischungen davon umfasst;
wobei M für 2H oder ein zweiwertiges Kation steht;
R₁ für CO₂R₃ steht, wobei R₃ für Alkyl steht;
R₂ für Wasserstoff, eine C₁₂-C₂₀-Alkylgruppe oder eine C₁₂-C₂₀-Alkenylgruppe steht; und
R₄ für Wasserstoff oder Alkyl steht; und
ein zweites Substrat, das eine zweite leitfähige Schicht umfasst, bereitstellt.

13. Verfahren nach Anspruch 12, bei dem das zweiwertige Kation ein zweiwertiges Kation von Mn, Co, Mg, Zn oder Cu umfasst.

14. Verfahren nach Anspruch 12, bei dem der Farbstoff ferner ein Tetraterpen, ein Carotinoid oder eine Mischung davon umfasst.

15. Verfahren nach Anspruch 14, bei dem das Tetraterpen Lycopin, gamma-Carotin, alpha-Carotin, beta-Carotin oder Mischungen davon umfasst und das Carotinoid Neurosporen, Spheroidin, Lycopin, Anhydrorhodovibrin, Spirilloxanthin oder Mischungen davon umfasst.

## Revendications

1. Cellule solaire à colorant comprenant un composé colorant représenté par la formule (I) : 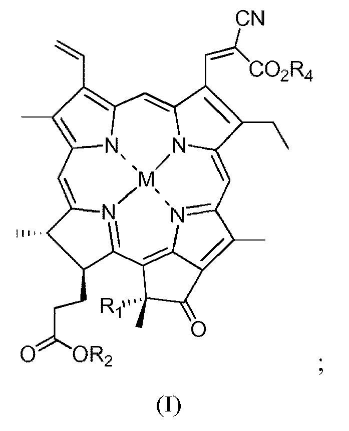 ou des mélanges de plusieurs de ces composés ;
dans laquelle formule M est 2H ou un cation divalent ;
R₁ est CO₂R₃, R₃ étant un alkyle ;
R₂ est l'hydrogène, un groupe alkyle en C₁₂-C₂₀ ou un groupe alcényle en C₁₂-C₂₀ ; et
R₄ est l'hydrogène ou un alkyle.

2. Cellule solaire à colorant selon la revendication 1, comprenant en outre :
une première couche conductrice disposée sur un premier substrat ;
une couche barrière disposée sur la première couche conductrice ;
une couche de nanoparticules de TiO₂ disposée sur la couche barrière ;
une couche de microparticules de TiO₂ disposée sur la couche de nanoparticules de TiO₂ ;
un colorant disposé sur la couche de nanoparticules de TiO₂ et/ou la couche de microparticules de TiO₂, le colorant comprenant un composé représenté par la formule (I) : 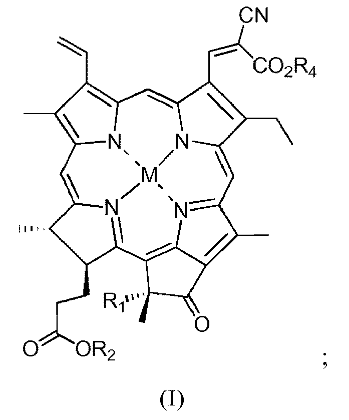 ou des mélanges de plusieurs de ces composés ;
dans laquelle formule M est 2H ou un cation divalent ;
R₁ est CO₂R₃, R₃ étant un alkyle ;
R₂ est l'hydrogène, un groupe alkyle en C₁₂-C₂₀ ou un groupe alcényle en C₁₂-C₂₀ ; et
R₄ est l'hydrogène ou un alkyle ;
une seconde couche conductrice disposée sur un second substrat ; et
une composition de régénération disposée entre la seconde couche conductrice et la couche de microparticules de TiO₂.

3. Procédé de préparation d'une cellule solaire à colorant comprenant :
la formation d'une première couche conductrice sur un premier substrat ;
la formation d'une couche barrière sur la première couche conductrice ;
la formation d'une couche de nanoparticules de TiO₂ ;
la formation d'une couche de microparticules de TiO₂ sur la couche de nanoparticules de TiO₂ ;
la disposition d'un colorant sur la couche de nanoparticules de TiO₂ et/ou la couche de microparticules de TiO₂, le colorant comprenant un composé représenté par la formule (I) : 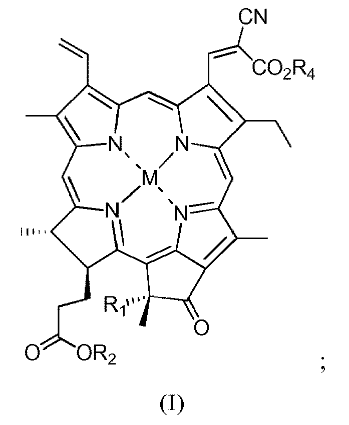 ou des mélanges de plusieurs de ces composés ;
dans laquelle formule M est 2H ou un cation divalent ;
R₁ est CO₂R₃, R₃ étant un alkyle ;
R₂ est l'hydrogène, un groupe alkyle en C₁₂-C₂₀ ou un groupe alcényle en C₁₂-C₂₀ ; et
R₄ est l'hydrogène ou un alkyle ;
la formation d'une seconde couche conductrice sur un second substrat ; et
la disposition d'une composition de régénération entre la seconde couche conductrice et la couche barrière.

4. Procédé selon la revendication 3 ou cellule solaire à colorant selon la revendication 2, dans lesquels le cation divalent comprend un cation divalent de Mn, Co, Mg, Zn ou Cu.

5. Procédé selon la revendication 3 ou cellule solaire à colorant selon la revendication 2, dans lesquels le colorant comprend en outre un tétraterpène, un caroténoïde ou un mélange de ceux-ci.

6. Procédé ou cellule solaire à colorant selon la revendication 5, dans lesquels le tétraterpène comprend du lycopène, du gamma-carotène, de l'alpha-carotène, du bêta-carotène ou des mélanges de ceux-ci ; et le caroténoïde comprend du neurosporène, du sphéroïdène, du lycopène, de l'anhydrorhodovibrine, de la spirilloxanthine ou des mélanges de ceux-ci.

7. Procédé selon la revendication 3 ou cellule solaire à colorant selon la revendication 2, dans lesquels le premier et/ou second substrat comprend du verre ou un polymère souple.

8. Procédé ou cellule solaire à colorant selon la revendication 7, dans lesquels le premier et/ou second substrat comprend un polymère souple comprenant du poly(téréphtalate d'éthylène), du poly(naphtalate d'éthylène) ou des mélanges de ceux-ci.

9. Procédé selon la revendication 3 ou cellule solaire à colorant selon la revendication 2, dans lesquels la première couche conductrice comprend de l'oxyde d'étain et d'indium (ITO), de l'oxyde de zinc dopé par de l'aluminium (AZO), du dioxyde d'étain dopé par de l'antimoine (ATO), du dioxyde d'étain dopé par du fluor (FTO), de l'oxyde d'indium dopé par de l'étain ou de l'oxyde de titane (TiO₂) dopé par une impureté conductrice.

10. Procédé selon la revendication 3 ou cellule solaire à colorant selon la revendication 2, dans lesquels la composition de régénération comprend des ions iodure et de l'iode.

11. Procédé selon la revendication 3 ou cellule solaire à colorant selon la revendication 2, dans lesquels la seconde couche conductrice comprend du platine.

12. Procédé de préparation d'une cellule solaire à colorant comprenant :
la fourniture d'un premier substrat comprenant une première couche conductrice et une couche de nanoparticules de TiO₂ ;
la disposition d'un colorant sur la couche de nanoparticules de TiO₂, le colorant comprenant un composé représenté par la formule (I) : 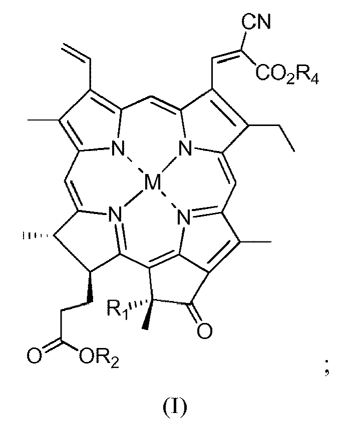 ou des mélanges de plusieurs de ces composés ;
dans laquelle formule M est 2H ou un cation divalent ;
R₁ est CO₂R₃, R₃ étant un alkyle ;
R₂ est l'hydrogène, un groupe alkyle en C₁₂-C₂₀ ou un groupe alcényle en C₁₂-C₂₀ ; et
R₄ est l'hydrogène ou un alkyle ; et
la fourniture d'un second substrat comprenant une seconde couche conductrice.

13. Procédé selon la revendication 12, dans lequel le cation divalent comprend un cation divalent de Mn, Co, Mg, Zn ou Cu.

14. Procédé selon la revendication 12, dans lequel le colorant comprend en outre un tétraterpène, un caroténoïde ou un mélange de ceux-ci.

15. Procédé selon la revendication 14, dans lequel le tétraterpène comprend du lycopène, du gamma-carotène, de l'alpha-carotène, du bêta-carotène ou des mélanges de ceux-ci ; et le caroténoïde comprend du neurosporène, du sphéroïdène, du lycopène, de l'anhydrorhodovibrine, de la spirilloxanthine ou des mélanges de ceux-ci.
